# EUROPÄISCHE PATENTANMELDUNG

(11) **EP 0 834 909 A2**
(43) Veröffentlichungstag der Anmeldung: **08.04.1998**
(21) Anmeldenummer: 97122692.3
(22) Anmeldetag: 04.09.1990
(51) Int. Cl.: H01L 21/22, H01L 21/263, H01L 29/32

(54) **Verfahren zur Erhöhung der Spannungsfestigkeit eines mehrschichtigen Halbleiterbauelements**

(30) Priorität: 28.09.1989 DE 3932489
(62) Teilanmeldung aus: 90117012.6
(71) Anmelder: SIEMENS AKTIENGESELLSCHAFT, 80333 München (DE)
(72) Erfinder: Die Erfindernennung liegt noch nicht vor

(57) **Zusammenfassung**

Zur Erhöhung der Spannungsfestigkeit eines Halbleiterbauelements, das eine Folge von Halbleiterschichten (1 bis 4) alternierender Leitungstypen aufweist und mit einer Spannung beaufschlagt wird, die wenigstens einen der die Schichten voneinander trennenden pn-Übergänge (7) in Sperrichtung vorspannt, wird lediglich im lateralen Bereich (LBr) des Randabschlusses (12) dieses pn-Übergangs (7) die Trägerlebensdauer durch Einbringen von Atomen mit Rekombinationseigenschaften reduziert.

## Beschreibung

Verfahren zur Erhöhung der Spannungsfestigkeit eines mehrschichtigen Halbleiterbauelements.

Die Erfindung bezieht sich auf Verfahren zur Erhöhung der Spannungsfestigkeit eines mehrschichtigen Halbleiterbauelementes nach dem Oberbegriff des Patentanspruchs 1.

Einige Verfahren dieser Art sind in dem Buch von W. Gerlach _{"}Thyristoren", erschienen als Band 12 der Buchreihe _{"}Halbleiter-Elektronik", herausgegeben von W. Heywang und R. Müller im Springer-Verlag, Berlin 1979, auf den Seiten 151 bis 159 beschrieben. Dort sind insbesondere in den Bildern 4.22 und 4.23 scheibenförmige Thyristoren gezeigt, deren Ränder in den Bereichen der in Sperrichtung vorgespannten pn-Übergänge jeweils positiv oder negativ abgeschrägt sind. Auf den Seiten 158 und 159 dieser Veröffentlichung ist eine andere Methode angegeben, bei der der in Sperrichtung vorgespannte pn-Übergang planar ausgeführt und durch einen oder mehrere konzentrische Feldbegrenzungsringe ergänzt ist, wobei letztere wie ein Spannungsteiler an der Oberfläche des Thyristors wirken und die Oberflächenfeldstärke soweit herabsetzen, daß ein Oberflächendurchbruch bis zu sehr hohen Sperrvorspannungen des pn-Übergangs vermieden wird.

Aus der deutschen Offenlegungsscshrift DE 27 38 152 A1 ist ein Festkörperbauelement, insbesondere ein Thyristor, bekannt, bei dem ein gesamter Bereich außerhalb der Steuerelektrode in seiner Ladungsträgerlebensdauer gegenüber dem Bereich unterhalb der Steuerelektrode abgesenkt ist, wobei die Absenkung nur so groß ist, daß das Bauelement zündfähig bleibt.

Der Erfindung liegt die Aufgabe zugrunde, Verfahren der eingangs genannten Art anzugeben, die eine deutliche Anhebung der Spannungsfestigkeit gewährleisten. Das wird erfindungsgemäß durch eine Ausgestaltung nach dem Patentanspruch 1 erreicht.

Das erfindungsgemäße Verfahren zeichnet sich insbesondere dadurch aus, daß sie in einfacher Weise, nämlich durch eine entsprechende Wahl der Diffusionszeit und -temperatur, eine quantitativ einstellbare Erhöhung der Spannungsfestigkeit ermöglichen. Insbesondere können sie auf solche Halbleiterbauelemente angewendet werden, deren Spannungsfestigkeit schon nach den bekannten Verfahren erhöht wurde, um eine weitere Erhöhung derselben zu erreichen.

Die Patentansprüche 2 und 3 sind auf bevorzugte Weiterbildungen der erfindungsgemäßen Verfahren gerichtet.

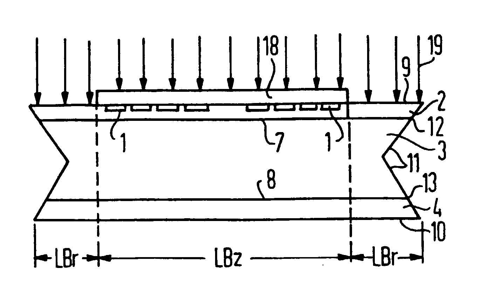

In der Zeichnung ist ein Thyristor mit einem aus dotiertem Halbleitermaterial, zum Beispiel Silizium, bestehenden Halbleiterkörper dargestellt. Er weist vier aufeinanderfolgende Schichten abwechselnder Leitungstypen auf. Von diesen bezeichnet man die aus den n-leitenden Teilschichten 1 bestehende Schicht als den n-Emitter, die p-leitende Schicht 2 als die p-Basis, die n-leitende Schicht 3 als die n-Basis und die p-leitende Schicht 4 als den p-Emitter.

Um eine hohe Spannungsfestigkeit des Thyristors zu gewährleisten, muß dafür Sorge getragen werden, daß ein oberflächenseitiger Durchbruch der pn-Übergänge 7 und 8 erst bei hohen Sperrspannungen eintritt. Zu diesem Zweck wird der Thyristorrand zum Beispiel, wie in der Zeichnung dargestellt, sowohl von der oberen Hauptfläche 9 als auch von der unteren Hauptfläche 10 ausgehend jeweils mit einem positiven Winkel abgeschrägt. Damit wird eine Absenkung der Oberflächenfelstärke im Bereich der in der seitlichen Begrenzungsfläche 11 liegenden seitlichen Randabschlüsse 12 und 13 der pn-Übergänge 7 und 8 erreicht, durch die die Gefahr des Durchbruchs an dieser Stelle herabgesetzt wird.

Bei dem in der Zeichnung dargestellten Thyristor wird zur Reduzierung der Trägerlebensdauer bzw. zur Erhöhung der Spannungsfestigkeit im lateralen Bereich LBr der seitlichen Randabschlüsse 12 und 13 nach einem erfindungsgemäßen Verfahren vorgegangen. Dabei wird zunächst der Bereich LBz mittels einer Maske 18, zum Beispiel aus lack, Oxid oder Metall, abgedeckt. Wird eine Lackmaske 18 verwendet, so wird diese in vorteilhafter Weise mittels an sich bekannter photolithographischer Schritte aus einer die Hauptfläche 9 zunächst vollständig bedeckenden Lackschicht strukturiert. Eine sich anschließende, maskierte Diffusion besteht aus einem Belegungsschritt, der zum Beispiel aus einer durch die Pfeile 19 angedeuteten, maskierten Implantation von Atomen der genannten Art in den unmittelbar unterhalb der Hauptfläche 9 und außerhalb der Maske 18 liegenden Teil der p-Basis 2 besteht und einem sich anschließenden Eintreibschritt, bei dem die in die p-Basis eingebrachten Atome weiter in den Halbleiterkörper eingetrieben werden, was zum Beispiel durch eine Erwärmung des Thyristors auf etwa 800°C während eines Zeitraumes von etwa zwei Stunden geschieht. Der Belegungsschritt kann anstelle der beschriebenen, maskierten Implantation auch aus einer maskierten Metallabscheidung der Atome mit Rekombinationseigenschaften bestehen, zum Beispiel mittels Aufdampfen bzw. Sputtern durch eine Metallmaske 18 hindurch, oder auch mittels einer ganzflächigen Metallabscheidung der Atome mit Rekombinationseigenschaften mit einer sich anschließenden photolithographischen Ätzstrukturierung zur Entfernung des auf LBz entfallenden Teils der abgeschiedenen Metallschicht. Auch bei diesen Varianten des erfindungsgemäßen Verfahrens schließt sich an den Belegungsschritt der bereits erwähnte Eintreibschritt an.

Als weiteres erfindungsgemäßes Verfahren zur Reduzierung der Trägerlebensdauer innerhalb von LBr kommt ein Implantationsverfahren in Betracht, bei dem die Atome mit Rekombinationseigenschaften mittels eines Ionenimplantationsschrittes mit entsprechend vergrößerter Beschleunigungsspannung ohne einen zusätzlichen Eintreibschritt außerhalb von LBz in die Schichten 2 bis 4 eingebracht und einem sich anschließenden Ausheilschritt unterzogen werden. Auch ein solches Implantationsverfahren ist in der Zeichnung durch die Pfeile 19 angedeutet. Nach dem Entfernen der maske 18 werden dann Elektroden und weitere Belegungen auf den Hauptflächen 9 und 10 angebracht.

## Patentansprüche

1. Verfahren zur Erhöhung der Spannungsfestigkeit eines scheibenförmigen Halbleiterbauelements, mit einer Emitterschicht (1) eines ersten Leitfähigkeitstyps, einer Basisschicht (2) eines zweiten Leitfähigkeitstyps, einer Basisschicht (3) des ersten Leitfähigkeitstyps und einer zweiten Emitterschicht (4) des zweiten Leitfähigkeitstyps, bei dem die Emitterschicht des ersten Leitfähigkeitstyps eine Verbindung mit einer Kathode (K) und die Emitterschicht des zweiten Leitfähigkeitstyps eine Verbindung mit der Anode (A) aufweist und bei dem ein erster pn-Übergang (7) zwischen der Basisschicht des ersten Leitfähigkeitstyps und der Basisschicht des zweiten Leitfähigkeitstyps und ein zweiter pn-Übergang (8) zwischen der Basisschicht des ersten Leitfähigkeitstyps und der Emitterschicht des zweiten Leitfähigkeitstyps besteht,
**dadurch gekennzeichnet,**
daß ein zentraler aktiver Bereich (LBz) des Halbleiterbauelements mit einer Maske (18) derart abgedeckt ist, daß lediglich in einem Bereich (LBr) von Randabschlüssen (12, 13), die zur Absenkung der Oberflächenfeldstärke vorhanden sind, eine Ionenimplantation mit Atomen, die Rekombinationseigenschaften aufweisen, im lateralen Bereich (LBr) außerhalb des zentralen aktiven Bereiches und innerhalb der Basiszone des zweiten Leitfähigkeitstyps und des ersten Leitfähigkeitstyps sowie in der Emitterschicht des zweiten Leitfähigkeitstyps erfolgt.

2. Verfahren nach Anspruch 1,
bei dem die Atome mit Rekombinationseigenschaften aus Gold oder Platinatomen bestehen.

3. Verfahren nach Anspruch 1,
bei dem das Halbleiterbauelement unmittelbar nach der Bestrahlung mit geladenen Teilchen ohne vorhergehenden Eintreibschritt getempert wird.
